(19) **Europäisches Patentamt / European Patent Office / Office européen des brevets**

(11) **EP 1 787 309 B1**

(12) **FASCICULE DE BREVET EUROPEEN**

(45) Date de publication et mention
de la délivrance du brevet:
**06.01.2010 Bulletin 2010/01**

(21) Numéro de dépôt: **05776167.8**

(22) Date de dépôt: **01.08.2005**

(51) Int Cl.:
***H01J 37/244*** (2006.01)

(86) Numéro de dépôt international:
**PCT/EP2005/053745**

(87) Numéro de publication internationale:
**WO 2006/013199 (09.02.2006 Gazette 2006/06)**

(54) **DISPOSITIF POUR L'ACQUISITION D'IMAGE ET/OU DE SPECTRES DE PERTES D'ENERGIE D'ELECTRONS**

VORRICHTUNG ZUR GEWINNUNG DES ABBILDES UND/ODER DER SPEKTREN EINES ELEKTRONENENERGIEVERLUSTES

DEVICE FOR OBTAINING THE IMAGE AND/OR SPECTRA OF ELECTRON ENERGY LOSS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **04.08.2004 FR 0408633**

(43) Date de publication de la demande:
**23.05.2007 Bulletin 2007/21**

(73) Titulaires:
• **CENTRE NATIONAL DE LA RECHERCHE SCIENTIFIQUE (CNRS)**
**75794 Paris Cedex 16 (FR)**
• **UNIVERSITE PARIS-SUD (PARIS 11)**
**91405 Orsay (FR)**

(72) Inventeurs:
• **PINNA, Henri**
**F-31400 Toulouse (FR)**

• **TENCE, Marcel**
**F-92130 Issy Les Moulineaux (FR)**

(74) Mandataire: **Novagraaf IP**
**122 rue Edouard Vaillant**
**92593 Levallois-Perret Cedex (FR)**

(56) Documents cités:
**EP-A- 0 409 209        US-A- 4 831 255**
**US-A1- 2004 000 641**

• **PATENT ABSTRACTS OF JAPAN vol. 2000, no. 22, 9 mars 2001 (2001-03-09) & JP 2001 148231 A (HITACHI LTD), 29 mai 2001 (2001-05-29)**
• **PATENT ABSTRACTS OF JAPAN vol. 2003, no. 12, 5 décembre 2003 (2003-12-05) & JP 2004 214057 A (HITACHI HIGH-TECHNOLOGIES CORP), 29 juillet 2004 (2004-07-29)**

**Description**

La présente invention concerne un dispositif pour l'acquisition d'images et/ou de spectres de perte d'énergie d'électrons. Elle s'applique en particulier à l'acquisition d'images en mode multimode (mode haute vitesse et mode haute résolution) et à l'acquisition rapide de spectres de perte d'énergie d'électrons de très grande dynamique.

L'évolution des besoins des laboratoires utilisant des microscopes électroniques comme outil d'investigation et notamment l'évolution des thématiques vers l'étude des matériaux à l'échelle nanométrique nécessite des moyens d'investigations de plus en plus performants. En microscopie électronique les techniques utilisées évoluent vers une exploitation quantitative des images, ce qui implique un développement des méthodes d'acquisition.

Un spectre de pertes d'énergie d'électrons est composé principalement de deux zones, une zone de faibles pertes (Low Loss ou L.L.), cette zone généralement à forte intensité comporte la raie de référence de perte nulle suivie de plasmons, la zone de pertes lointaines (Core Loss ou C.L.) s'étend habituellement de quelques centaines jusqu'à quelques milliers d'électrons-Volts (eV). Le rapport des intensités entre ces 2 régions peut atteindre $10^9$ et ne permet pas, dans l'art antérieur, l'enregistrement simultané de l'ensemble du spectre.

Les détecteurs actuellement utilisés pour l'enregistrement de ces spectres sont du type à transfert de charge DTC ou CCD (pour Charge Coupled Device) fortement refroidis, épais (front-illuminated, c'est-à-dire illuminé par l'avant) ou amincis (back-illuminated pour illuminés par l'arrière) lorsque l'on recherche un meilleur rendement ou que la longueur d'onde l'exige (longueur d'onde inférieure à 450 nm).

Les meilleurs détecteurs actuellement disponibles offrent une dynamique de l'ordre de 10.000 très exceptionnellement on peut approcher 100.000, c'est-à-dire qu'il leur manque un facteur de 100.000 ou 10.000, respectivement, pour capter simultanément des rapports d'intensité de $10^9$. Les cinq ou quatre décades manquantes imposent un enregistrement du spectre en deux séquences indépendantes. Pour enregistrer les zones de faibles pertes, on commence par une exposition d'une durée très courte (100 $\mu$s, par exemple). Si le nombre d'électrons du spectre est élevé, pour éviter les problèmes de saturation, on lit généralement le détecteur ligne par ligne ce qui entraîne une durée non négligeable, puis on rince complètement le détecteur et l'on effectue une seconde exposition pour enregistrer la zone de pertes lointaines, avec une durée d'exposition beaucoup plus élevée pour obtenir un signal significatif. On remarque que, dans ce cas, la zone de faibles pertes du spectre peut être très fortement saturée. Au terme de cette seconde exposition, on procède à la lecture du détecteur en sommant les contenus des lignes partie par partie (sommation appelée "binning partiel") ou toutes les lignes (sommation appelée "binning total") en fonction du taux de remplissage des pixels.

L'ensemble de ces opérations implique que la prise de vue soit lente ce qui nuit à l'acquisition d'un spectre de perte d'énergie d'électrons et, en particulier interdit l'acquisition rapide de spectre de perte d'énergie d'électrons de très grande dynamique.

De plus, les dispositifs de l'art antérieur imposent une stabilité de la source d'alimentation (100.000 à 1.000.000 volts) pendant une minute, voire davantage, ce qui les rend vulnérables aux moindres variations de tension d'alimentation.

Enfin, les dispositifs de l'art antérieur ne permettent pas une grande précision de positionnement du pic d'énergie, précision qui est nécessaire pour repérer les distributions caractéristiques dans le spectre de perte d'énergie. JP 2001148231 décrit l'utilisation d'une détecteur de particules chargées (du type CCD) dans un microscope électronique à balayage à transmission.

La présente invention vise à répondre à ces besoins.

À cet effet, la présente invention vise un dispositif pour l'acquisition d'images et/ou de spectres de perte d'énergie d'électrons, caractérisé en ce qu'il comporte :

- un capteur d'image,
- une commande d'au moins un déflecteur adapté à exposer alternativement au moins deux parties photosensibles du capteur d'image, des moyens de lecture du capteur adapté à générer un signal représentatif de l'image captée par chaque partie photosensible du capteur d'image,
- un moyen de synchronisation des déflecteurs et des moyens de lecture adapté à commander successivement, pour chaque partie photosensible (LL et CL), d'une part l'exposition de ladite partie photosensible et, d'autre part, la lecture d'une autre partie photosensible différente, et
- un moyen de combinaison de deux parties d'image pour former un spectre.

Grâce à ces dispositions, la dynamique du capteur peut être augmentée en faisant varier la durée d'exposition des différentes parties photosensibles. De plus, les expositions et lectures des différentes zones photosensibles du capteur d'image permettent de capter l'image de différentes parties d'un spectre de perte d'énergie, la prise d'image pouvant s'effectuer de manière continue

Selon des caractéristiques particulières, le moyen de synchronisation est adapté à commander des durées d'exposition différentes pour différents intervalles de temps successifs d'exposition.

Grâce à ces dispositions, les parties du spectre présentant des intensités très différentes peuvent être captées pendant des durées d'exposition adaptées.

Selon des caractéristiques particulières, le moyen de synchronisation est adapté à ce que les vitesses de lectures des différentes zones photosensibles soient différentes.

Selon des caractéristiques particulières, le moyen de lecture est adapté à effectuer, d'une part, une lecture ligne à ligne d'une partie photosensible et, d'autre part, une accumulation de charges électriques de photosites d'une partie photosensible avant lecture.

Grâce à ces dispositions, la durée de lecture peut être modifiée d'une partie photosensible à une autre, par exemple pour correspondre aux durées d'exposition différentes des différentes parties photosensibles.

Selon des caractéristiques particulières, le dispositif tel que succinctement exposé ci-dessus comporte un moyen de sommation adapté à additionner les valeurs des signaux correspondant à différentes lignes d'une partie lue ligne à ligne.

Selon des caractéristiques particulières, le capteur d'image comporte, pour au moins une partie photosensible, au moins deux parties dont les moyens de lecture sont indépendants.

Grâce à ces dispositions, le rapport signal/bruit du dispositif est amélioré pour les zones photosensibles lues les plus lentement.

Selon des caractéristiques particulières, le dispositif tel que succinctement exposé ci-dessus comporte deux déflecteurs adaptés à décaler l'image selon les deux directions du capteur d'image.

Selon les caractéristiques particulières, le dispositif tel que succinctement exposé ci-dessus comporte, en outre, un déflecteur rapide d'effacement adapté à déporter le spectre hors du détecteur pendant le positionnement de chaque déflecteur adapté à exposer alternativement au moins deux parties photosensibles du capteur d'image.

Ainsi, le temps de réponse de la déflection est négligeable par rapport aux temps de pose utilisés pour l'enregistrement des différentes parties du spectre. On évite ainsi que le détecteur enregistre une traînée due au passage du spectre pendant les déplacements du faisceau d'une zone photo sensible à l'autre.

Selon les caractéristiques particulières, le déflecteur qui agit sur le spectre dans le sens dispersif en énergie est de type électrostatique, la variation de potentiel étant obtenue par un commutateur électronique qui permet le basculement instantané de la tension de consigne haute à la masse.

Ainsi, on met en oeuvre une commutation rapide tout en conservant la stabilité et la précision des deux tensions.

Selon des caractéristiques particulières, le dispositif tel que succinctement exposé ci-dessus comporte un moyen de transfert optique comportant au moins une lentille.

Selon des caractéristiques particulières, le dispositif tel que succinctement exposé ci-dessus comporte un spectromètre adapté à former, à la surface du capteur d'image, un spectre de perte d'énergie d'électrons.

Selon des caractéristiques particulières, les moyens de lecture du capteur sont adaptés à appliquer des gains différents aux signaux issus des deux parties photosensibles du capteur d'image.

D'autres avantages, buts et caractéristiques de la présente invention ressortiront à la lecture de la description qui va suivre, faite dans un but explicatif et nullement limitatif en regard des dessins annexés dans lesquels :

- la figure 1 représente, schématiquement, un mode de réalisation particulier du dispositif objet de la présente invention ;
- la figure 2 représente, schématiquement, les blocs fonctionnels d'un circuit électronique illustré en figure 1 ;
- la figure 3 représente, schématiquement, un chronogramme de fonctionnement d'un capteur d'image et de circuits électroniques additionnels illustrés en figures 1 et 2 pour un fonctionnement en mode haute vitesse ;
- la figure 4 représente, schématiquement, un chronogramme de fonctionnement d'un capteur d'image et de circuits électroniques additionnels illustrés en figures 1 et 2 pour un fonctionnement en mode haute résolution ;
- les figures 5A et 5B représentent, schématiquement, un capteur d'image du dispositif illustré en figure 1 et
- la figure 6 représente des parties de spectres de perte d'énergie obtenus par la mise en oeuvre du dispositif illustré aux figures 1 à 5.

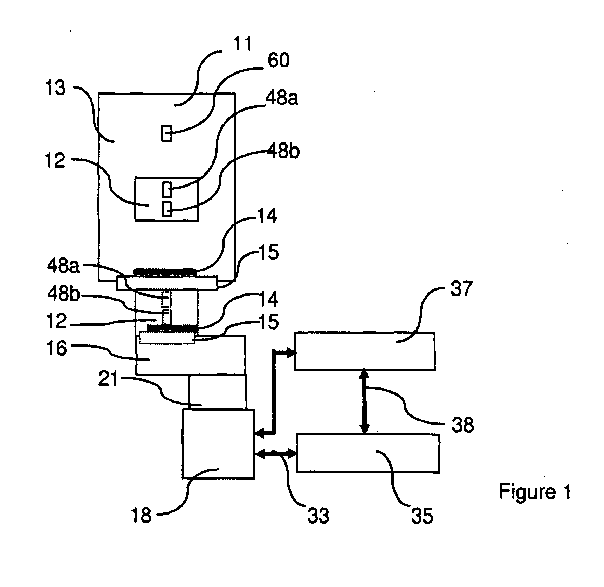

Le dispositif 10 objet de la présente invention dont la structure est illustrée en figure 1 est utilisé pour former des images en mode "Haute Vitesse (HV)" ou en mode "Haute Résolution (HR)" et détecter les électrons d'un spectre de pertes d'énergie formés sur un microscope électronique 11 équipé d'un spectromètre 12 disposé dans ou en sortie de la colonne 13 du microscope électronique 11. La conversion électrons-photons est réalisée par un scintillateur 14 placé sur un hublot 15 qui assure aussi l'étanchéité au vide.

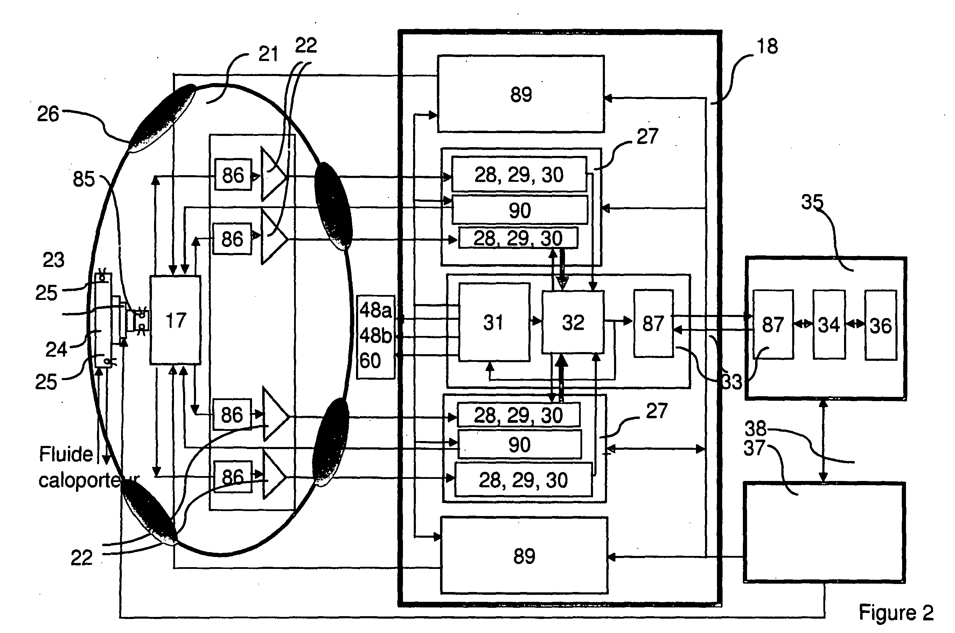

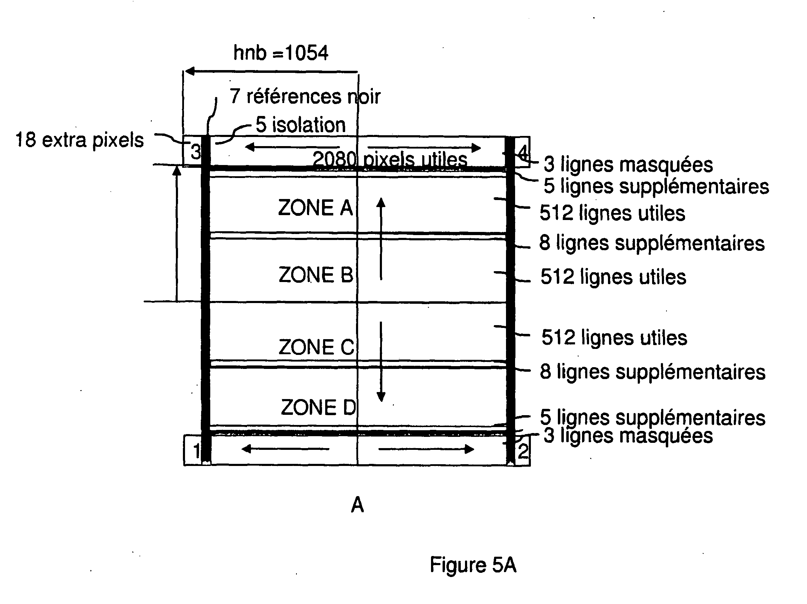

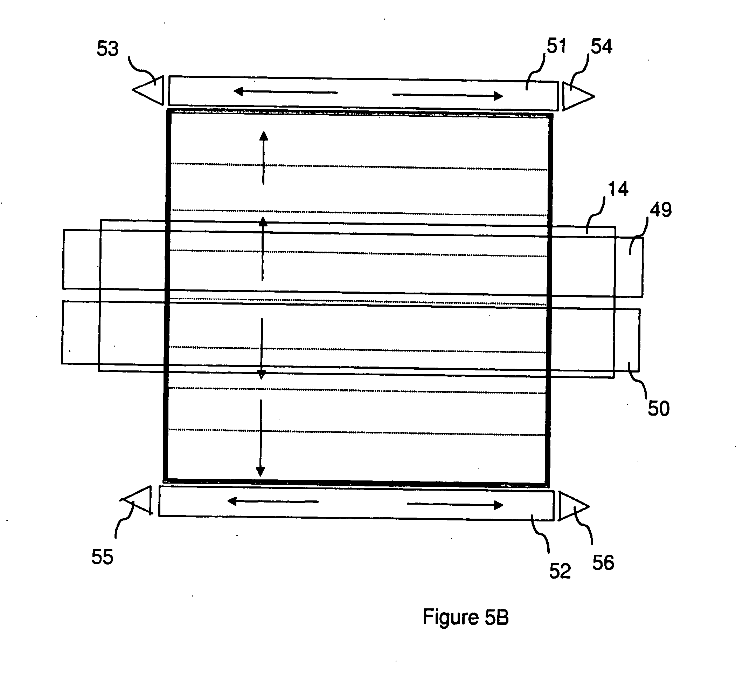

Un moyen de transfert optique 16 permet de reformer une image identique sur la partie sensible d'un capteur d'image 17 à dispositif de transfert de charges, ou DTC, connu sous l'acronyme anglais "CCD" pour "charge coupled device". Ce capteur d'image 17 se trouve dans une tête de détection 21 (voir figure 2) et est refroidi entre - 30°C et -60°C suivant le besoin, c'est-à-dire suivant les durées de pose nécessaires. Par exemple, le capteur d'image est un produit commercial de référence ATMEL TH7899M qui comporte 2048 x 2048 pixels de 14 x 14 $\mu$m. Il est du type à transfert de trame et possède deux registres de lecture munis chacun de deux voies (voir description de la figure 5). Un boîtier électronique de traitement 18 est accolé à une tête de détection comportant le capteur d'image 17.

Le moyen de transfert optique 16 comporte préférentiellement des lentilles en verre à plomb et éventuellement des miroirs plutôt que des fibres optiques afin que les rayons X générés par le scintillateur 14 ne perturbent pas le système.

Le spectromètre 12 et le microscope électronique 11 comportent un déflecteur 48 de type électrostatique ou de type magnétique qui décale l'image formée sur le capteur d'image 17 entre les deux zones photosensibles correspondant aux deux registres de lecture.

La structure générale des circuits électroniques de traitement du boîtier électronique 18 est illustrée en figure 2. Une tête de détection 21 renferme un échangeur thermique 24 des sondes de température 25, des composants à effet Peltier 23 reliés thermiquement par un "doigt froid" 85 au capteur d'image 17 (voir la description des ces capteur d'image 17 en figure 5A et 5B). Les sorties du capteur d'image 17 sont reliées à des filtres passe-haut 86, dont les sorties sont connectées à des préamplificateurs 22. Les sorties des préamplificateurs 22 traversent des connecteurs hermétiques 26. Des circuits de transposition de niveaux 89 effectuent une adaptation de niveau (translation et amplification) pour adapter l'amplitude et la puissance des signaux issus du contrôleur aux besoins du capteur. On remarque que ces niveaux sont réglables à partir d'un ordinateur 35 et peuvent donc être facilement adaptés à un autre type de détecteur.

Un circuit électronique de traitement 27 comporte, pour chaque voie de lecture (les sorties des préamplificateurs 22), des moyens d'amplification 28, des moyens de traitement analogique (échantillonneur bloqueur, sommateur, compensation dynamique et compensation statique pour réglage du niveau du seuil en l'absence de signal et avec un temps très court, ces réglage étant effectués automatiquement une valeur de 50 ADU sur 65535 en mode HR est très stable), 29 et des moyens de numérisation 30. Un contrôleur 31 commande une unité arithmétique 32 et commande les déflecteurs 48a, 48b et éventuellement un déflecteur rapide d'effacement 60 (en anglais « blanking ») pour exposer alternativement au moins deux parties photosensibles du capteur d'image 17 et déplacer le spectre hors du détecteur, lorsque le déflecteur 48 est sollicité. Le déflecteur rapide 60 est préférentiellement situé en haut de colonne. Le déflecteur rapide d'effacement 60 est adapté à déporter le spectre hors du détecteur pendant le positionnement de chaque déflecteur 48a et 48b. Le déflecteur 48a agit sur le spectre dans le sens dispersif en énergie, horizontal sur la figure 5A et est préférentiellement de type électrostatique. Le déflecteur 48b agit perpendiculairement à l'axe du spectre et est préférentiellement de type magnétique. Le contrôleur 31 constitue un moyen de synchronisation du déflecteur et des moyens de lecture du capteur d'image 17. Le contrôleur 31 commande successivement, pour chaque partie photosensible, d'une part l'exposition de ladite partie photosensible et, d'autre part, la lecture d'une autre partie photosensible différente.

Une connexion de l'unité arithmétique 32 est reliée à un transmetteur récepteur 87 lui-même relié à une ligne série à haut débit 33. Les signaux de sortie véhiculés par la ligne série 33 sont reçus par une carte électronique spécifique 34 de transmission-réception disposée dans un ordinateur (par exemple de type "PC" pour personal computer signfiant ordinateur personnel en français) 35 qui est, par ailleurs équipé d'une carte PCI ("Peripheral Component Interconnect" pour périphérique d'interconnexion de composants) 36 ultra rapide (80 MOctets/s) qui reçoit les données parallèles (20 lignes) de la ligne série à haut débit 33.

Un coffret d'alimentation et de contrôle 37 est piloté par l'ordinateur 35 au travers d'une ligne RS232 optocouplée 38. Le coffret d'alimentation et de contrôle 37 assure l'alimentation électrique de l'électronique mais aussi toutes les fonctions de mesure et de contrôle de la température du capteur d'image 17 ainsi que des fonctions de sécurité, tant pour les aspects thermiques que pour les aspects relatifs aux tensions limites que peut supporter le capteur d'image 17 sans être endommagé.

Les composants et circuits 90 assurent, d'une part la polarisation du capteur d'images 17 et d'autre part la mesure des différentes températures nécessaires pour la régulation de température et la sécurité du capteur d'image. Les polarisations du capteur d'images 17 sont réglables à partir de l'ordinateur 35

Le dispositif illustrés en figures 1 et 2 assure une double fonction : un fonctionnement en mode haute vitesse et un fonctionnement en mode haute résolution, décrit plus loin.

Le fonctionnement en mode "haute vitesse", comporte 3 gammes de fonctionnement correspondant à 42 (mode dit « HV3 »), 24 (mode dit « HV2 ») et 13 (mode dit « HV1 ») images par seconde avec un temps de pose nul. Ce mode vidéo permet d'effectuer les mises au point du microscope manuellement ou automatiquement et l'enregistrement en temps réel de séquences d'images nécessaires pour l'observation et l'enregistrement de phénomènes transitoires rapides tels que le déplacement de dislocations par exemple ; à l'inverse des caméras vidéo utilisées dans l'art antérieur, ce mode conserve le même champ d'observation que le mode "haute résolution" (voir plus loin). Le rythme de lecture est adapté en réglant le temps d'exposition.

Le convertisseur analogique numérique rapide nécessite un temps minimum de 45 ns pour effectuer correctement une conversion, la fréquence d'échantillonnage maximum est de 10 MHz.

Il en résulte, dans ces conditions, et ceci pour rester dans une configuration simple que la fréquence utilisée pour lire le capteur d'image 17 avec ce convertisseur ne doit pas dépasser 10 MHz.

Comme mentionné plus haut, on note que le convertisseur requiert un temps minimum de 45 ns pour l'échantillonnage. À la fréquence de 10 MHz, la durée du palier de signal est de 50 ns. Il est essentiel de positionner temporellement les principaux signaux fournis par le contrôleur 31 à l'unité de traitement 27 en fonction du retard du signal analogique traité. Avec une fréquence horloge de 64 MHz le pas de réglage du retard est de 7.813 ns. Dans ces conditions, il est préférentiel que cette durée atteigne au moins 52.81 ns. En fonctionnant à une fréquence de lecture du CCD à 8 MHz, cette durée est 62.5 ns, ce qui laisse une marge suffisante de 9.69 ns. Avec cette fréquence de lecture du capteur d'image 17, le rythme est peu modifié, la mise au point est facilitée et le fonctionnement s'en trouve fortement sécurisé. Il faut aussi remarquer qu'à cette fréquence le bruit de lecture est encore très acceptable comme nous l'écrirons plus loin.

Le tableau suivant mentionne les performances obtenues. Le temps d'exposition minimum est donné par les résultats donnés par le tableau précédent. L'acquisition, le traitement et la visualisation d'une image s'effectuent pendant le temps d'exposition de l'image précédente. Le temps d'exposition équivalent est calculé relativement au mode haute résolution (voir ci-dessous) sans binning (ou sommation) et en pleine fenêtre.

| Binning | Temps de lecture (ms) | Temps d'exposition typique (ms) | Rythme (images/s) | Temps d'exposition équivalent HR, B 1x1 (ms) | Nombre de pixels | Résolution Spatiale ($\mu$m) |
|---|---|---|---|---|---|---|
| 8 | 23,74 | 25 | 20,50 | 159,3 | 256x 256 | 112 |
| 4 | 41,28 | 50 | 10,96 | 159,3 | 512x 512 | 56 |
| 2 | 76,31 | 100 | 5,67 | 159,3 | 1024x 1024 | 28 |

Le signal vidéo est échantillonné sur le palier de référence et sur le palier de signal. Il est aussi 'bloqué' sur le palier de référence.

La bande passante nécessaire de la voie d'amplification pour une fréquence de lecture du CCD de 8 MHz est de 37.9 MHz. Pour chacun des signaux nous donnons la fréquence et la durée :

| | | | |
|---|---|---|---|
| Pour les signaux de décalage horizontaux | PhiL : | 8 MHz | 62.5 ns |
| Pour le signal de sommation | PhiS : | 4 MHz | 187.5 ns |
| Pour le signal de Reset | PhiR : | 4 MHz | 37.5 ns |
| Blocage | | 4 MHz | 62.5 ns |
| Echantillonnage : | HVx | 8 MHz | 62.5 ns |
| Volume de données par image en mode HV3: | | 131 kilo octets | |

Temps d'enregistrement avec visualisation en temps réel sans recours au disque dur avec 512 MO disponibles (1 GO RAM) sans compression : 215 s.

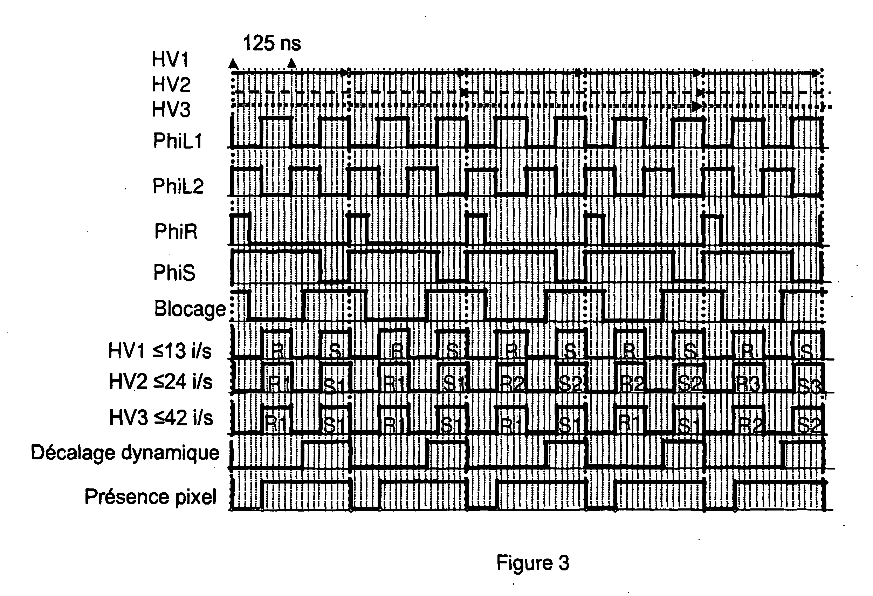

Pour les prises de séquences d'images les chronogrammes donnés sur la figure 3 indiquent qu'ils sont identiques au précédent. Le binning horizontal est réalisé par sommation numérique par l'unité arithmétique 32.

Volume de données par image en mode HV2 : 524 kO

Temps d'enregistrement avec visualisation en temps réel sans recours au disque dur avec 512 MO disponibles (1 GO RAM) : 54 s

Volume de données par image en mode HV1 : 2048 kO

Temps d'enregistrement avec visualisation en temps réel sans recours au disque dur avec 512 MO disponibles (1 GO RAM) : 13.5 s

Dans le mode de réalisation décrit ici, les durées d'exposition faibles et la fréquence de lecture relativement élevée rendent préférentiel un fonctionnement en non MPP (pour Multi Pinned Phase, type d'architecture de CCD permettant de réduire le courant d'obscurité par un facteur 25) la capacité maximum des puits de potentiel du registre de lecture est de HV1 530 k e-, le bruit total calculé pour une température de fonctionnement à -30°C est de :

| | | |
|---|---|---|
| HV1 : | 530 ke- | 48 e- |
| HV2 : | 1060 ke- | 63 e- |
| HV3 : | 2126 ke- | 89 e- |

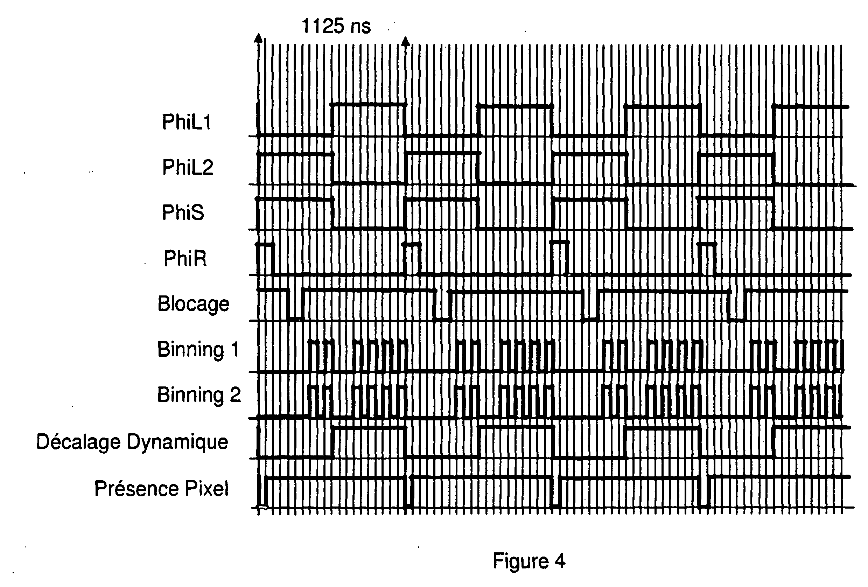

En mode de fonctionnement haute résolution spatiale et à faible bruit, la pleine image sans binning est lue en 1.27 seconde. La figure 4 montre que la fréquence de lecture est de 889 kHz.et que la fréquence d'échantillonnage est de 8 MHz, la bande passante de la voie d'amplification à cette fréquence de lecture du CCD est de 14.1 MHz. Un échantillonneur bloqueur situé dans la partie traitement 29 est en blocage pendant 125 ns sur le palier de référence, il permet notamment d'éliminer l'effet de décalage de la ligne vidéo, dû au filtre passe-haut 86 à l'entrée du préamplificateur 22.

Cela laisse le temps d'appliquer un double échantillonnage sur le palier de référence et un quadruple échantillonnage sur le palier de signal. Un signal de correction dynamique permet de compenser l'effet du couplage capacitif grille-source sur l'étage de sortie du CCD pendant la lecture du pallier de signal.

Pour une charge maximum en imageur haute résolution de 209 ke-, soit un gain de conversion de 3,19 e-/ADU, le bruit total mesuré est de 17 e-. Le gain électron par pixel sur électron incident sur le scintillateur est de 54.

En haute résolution les binning 2x2, 4x4 ou 8x8 peuvent être utilisés.

Pour tous les modes, l'image peut être fenêtrée. En haute résolution les charges du CCD située hors fenêtre sont transférées à haute vitesse.

Hors lecture, la tâche de fond est le rinçage du détecteur.

Revenons à l'enregistrement d'un spectre EELS et prenons comme hypothèse un spectre de perte d'énergie immobile, l'acquisition nécessite l'enchaînement des séquences suivantes :

1. Rinçage du détecteur
2. exposition pour la zone de faibles pertes ("pose LL")
3. lecture de la zone de faible perte
4. exposition pour la zone de pertes lointaines ("pose CL")
5. lecture de la zone de pertes lointaines

le rinçage et les temps de lecture sont des temps morts (c'est-à-dire qu'ils ne permettent pas d'effectuer une nouvelle exposition) que la mise en oeuvre de la présente invention permet d'éliminer en créant une concomitance lectures et exposition de capteur d'image (on ne prend pas en compte le rinçage, la lecture continue rinçant le capteur en en retirant les charges crées par effet thermique). De plus, le dispositif objet de la présente invention dote l'enregistrement d'une dynamique qui peut atteindre $10^9$, ce qui correspond au rapport maximum des intensités entre la zone de faibles pertes et la zone de pertes lointaines.

À cet effet, la présente invention met en oeuvre un séquencement d'étapes de fonctionnement du capteur d'image qui est détaillée ci-après pour un capteur d'image particulier, la présente invention ne se limitant pas à ce type de capteur d'image mais s'étend à tout capteur d'image présentant au moins deux registres de lecture situés de part et d'autre de la zone de détection.

La structure du capteur d'image CCD 7899M est munie de quatre zones de 520 lignes dans lesquelles les transferts de charges verticaux peuvent être réalisés indépendamment. La figure 5A représente la structure du TH7899 Les zones A et B sont lues dans le registre A, les zones C et D sont lues dans le registre B. Pour la mise en oeuvre de la présente invention, la séparation en quatre zones (CCD à transfert de trame) est préférentielle, elle offre une plus grande souplesse de gestion des données, mais n'est pas indispensable.

La présente invention peut mettre en oeuvre des capteurs d'image amincis ou pas ainsi que des dispositifs à micro-lentilles ou à interlignes. Les détecteurs à pixels actifs de type APS (Active Pixels Sensor) à transistors MOS complémentaires ou CMOS (pour Complementary Metal Oxide Semiconductor) sont aussi utilisables mais sont, à la date du dépôt de la présente demande de brevet, pénalisés par des performances de sensibilité et de dynamique moindres. En revanche, il est préférable de disposer d'une déflection verticale et d'une déflection horizontale sur le spectromètre afin de placer le spectre en position sur la zone B pour les faibles pertes et en zone C pour les pertes lointaines et d'un déflecteur d'effacement.

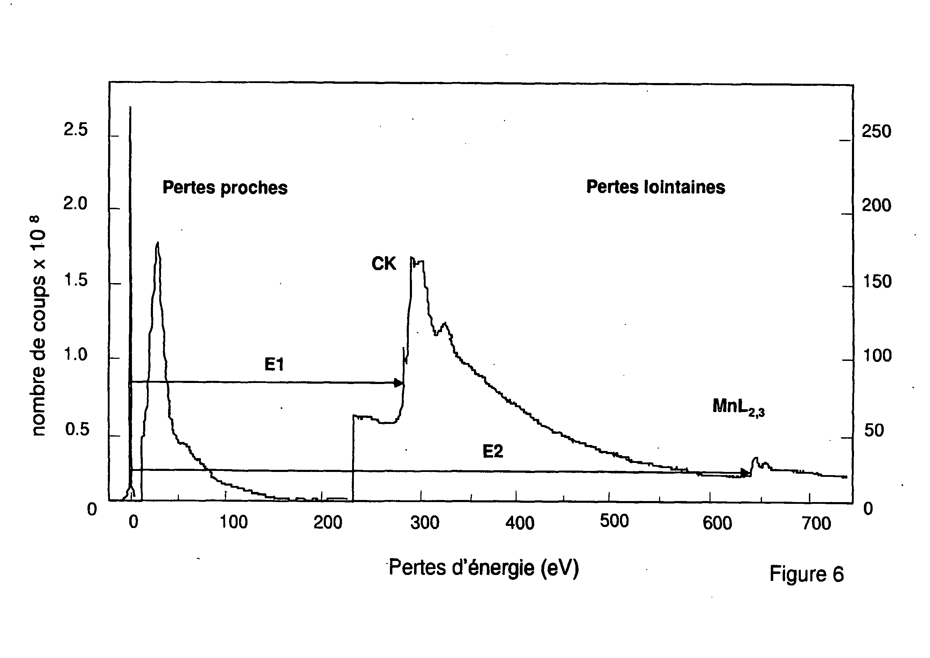

L'ordinateur personnel 35 constitue un moyen de combinaison des signaux issus des différentes parties du capteur d'image pour former un spectre. L'ordinateur personnel 35 constitue aussi un moyen de sommation adapté à additionner les valeurs des signaux correspondant à différentes lignes d'une partie du capteur d'images 17 lue ligne à ligne. Un exemple de spectre est donné en figure 6.

Les figures 5A et 5B illustrent la mise en oeuvre du procédé objet de la présente invention. Dans ces figures, la partie haute 49 (zone B) du capteur d'image 17 est dévolue aux faibles pertes, la partie basse 50 (zone C) étant spécialisée pour les pertes lointaines. Les zones "B" et "C" illustrées en figures 5A et 5B servent au transfert de trame en zone de stockage laquelle est lue, ligne à ligne, pendant l'exposition des parties photosensibles.

Pour l'acquisition en mode continu, qui convient pour un spectre image ou pour l'acquisition d'un spectre ligne en mode multi acquisition, on privilégie la réduction du temps d'acquisition d'un spectre afin de rester sur des durées d'enregistrement n'excédant pas quelques minutes en imagerie filtrée.

On rappelle qu'une image filtrée est obtenue par l'enregistrement de milliers de spectres ligne, cependant un spectre ligne est lui aussi rarement enregistré en une seule acquisition. En effet, cela est intéressant pour diminuer les effets de dérive du spectre, d'une part, par recalage en utilisant la position de la perte nulle et, d'autre part, par la réduction du courant thermique du capteur d'image 17 dont l'effet n'est pas négligeable quand les charges de toutes les lignes sont sommées. Avec un refroidissement à -50°C le courant thermique du capteur produit un bruit de 3 électrons pour une sommation (binning) de 1x256 pixels et une pose de 1 s.

Le déplacement du spectre utilise une stratégie particulière, notre dispositif comporte, dans son mode de réalisation particulier illustré en figure 2, trois signaux de commande issus du contrôleur 31 et qu'il est possible de synchroniser avec une grande précision temporelle, adaptés aux caractéristiques des différents déflecteurs.

Comme l'illustre les figures 5A et 5B, le capteur d'image 17 comporte deux registres de lecture 51 et 52 et quatre voies de lecture 53 à 56.

Dans le mode de réalisation illustré aux figures, la hauteur utile du spectre atteint 3.5 mm et occupe donc 250 lignes du capteur d'image 17, en fait ce dernier comporte 2080 lignes, le sous multiple le plus proche est 260 pixels. Le capteur d'image 17 est donc virtuellement découpé en 8 régions, comme illustré en figure 5B. Ce découpage dépend de la dimension du spectre dans le sens non dispersif en énergie et doit être optimisé en fonction de ce paramètre.

Il est maintenant possible de décrire les moyens qui permettent d'annuler les temps morts et d'atteindre la dynamique nécessaire sur l'enregistrement. Nous avons à titre d'exemple donner des temps d'enregistrement pour le TH7899M qui comporte 2080 x 2080 pixels utiles et dont les caractéristiques principales sont :

- pixels de 14 x 14 $\mu$m
- le temps de transfert vertical d'une ligne, Ttvl est de 6 $\mu$s
- la fréquence de lecture maximum des registres est de 8 MHz, elle peut être abaissée pour la lecture des LL afin de diminuer le bruit de lecture

Calculons dans ces conditions, cela sera nécessaire pour la suite, le temps de lecture d'une ligne :

$$Tll = 1054 * \frac{1}{Fl}$$

FI est la fréquence de lecture

Première étape : transfert vertical sans lecture du registre 52 des charges accumulées dans la zone de pertes lointaines ("CL") pendant l'exposition du spectre précédent et exposition de la zone de faibles pertes ("LL"). Le spectre est en 49.

a) Pour le transfert de la zone de pertes lointaines CL :

N=8 (découpage du CCD en 8 zones)
Hauteur du spectre 3,640 mm

$$Nl = \frac{2080}{N} = \frac{2080}{8} = 260$$

Le temps de transfert des CL est :

$$TtCL = \frac{2080}{N} * Ttvl = 260 * 0,006 = 1,560ms$$

b) Le temps de pose des LL est :

$$TpLL = TtCL = 1,560ms$$

Deuxième étape : exposition de la zone de pertes lointaines CL, lecture de la zone de faibles pertes LL ligne à ligne et lecture du registre de lecture 52 dans lequel sont sommées les charges des CL du spectre précédent. Le spectre est en 50.

a) Pour la lecture de la zone de faibles pertes LL :

$$TiLL = Til * Nl + Nl * Ttvl$$

Avec

$$Fl = 8 \text{ MHz}$$

$$TiLL = 1054 * \frac{1}{8 * 10^6} * 260 + 260 * 6 * 10^{-6}$$

$$TiLL = 35,815 \text{ ms}$$

b) Pour la lecture de la zone de pertes lointaines CL du spectre précédent, il est recommandé de choisir une fréquence optimale pour pouvoir réduire le bruit de lecture à une valeur aussi faible que possible :

$$FICL = \frac{1054}{TiLL} = 29,43 * 10^3$$

$$TiCL = \frac{1054}{FICL} = 35,815 \text{ ms}$$

Le rapport signal / bruit est renforcé en diminuant considérablement la fréquence de lecture du capteur d'image 17. On réduit ainsi substantiellement le bruit de lecture du capteur d'image 17 et le bruit de l'électronique par limitation de la bande passante. Ce réglage de la bande passante est optimisé par le multi échantillonnage numérique corrélé que nous utilisons. Rappelons que le double échantillonnage corrélé Correlated Double Sampling en anglais a pour but de pratiquement éliminer le bruit de reset. Avec un convertisseur rapide, il est possible d'échantillonner N fois sur chaque palier et donc de réduire par $N^{0.5}$ certains bruits affectant le signal.

Le bruit total est ainsi réduit à 5 é-. Cette valeur est obtenue avec une température du détecteur de -30°C, un temps de pose de 50 ms en mode MPP et une sommation, ou binning, 1x256. On remarque que, dans ces conditions, le dispositif permet de discerner un électron unique du spectre. Pour la lecture de la zone de pertes lointaines CL, avec la même température, la profondeur du puits de potentiel atteint 530 ke-, avec une sommation ou binning 1x1 et en fonctionnement en non MPP le bruit total est plus élevé

c) Pour l'exposition de la zone de pertes lointaines CL

Avec les choix a) et b) :

$$TpCL = 35,815 \text{ ms}$$

Préférentiellement, on applique aux voies de lecture des CL un gain différent, préférentiellement supérieur, par exemple quatre fois plus élevé, qu'aux voies de lecture des LL. On améliore ainsi le rapport signal/bruit. La profondeur du puits de potentiel est de 132,5 ke- soit Ga ce rapport. Avec ces données, on peut maintenant calculer le gain de dynamique

$$Gd = \frac{TpCL}{TpLL} * Nl * Ga$$

$$Gd = \frac{35,815}{1,560} * 260 * 4 = 23877$$

La dynamique du dispositif objet de la présente invention dans ce mode de fonctionnement est égale à :

$$Dg = Gd * Dc$$

Dg est la dynamique globale
Dc est la dynamique du capteur d'image 17 et de son électronique associée,

$$Dc = \frac{CHmaxCL}{NoiseCL} = \frac{132,5 * 10^3}{5} = 26500$$

$$Dg = 23877 * 26500 = 0,633 * 10^9$$

On peut donc dire que l'amélioration de la dynamique est obtenue par la multiplication de trois facteurs :

1. Le rapport des durées d'exposition pour les zones 49 et 50 et
2. Le rapport du nombre de lignes associées dans les zones 49 et 50 et
3. le rapport des gains des zones 50 et 49.

On remarque qu'en mettant en oeuvre la présente invention, les temps morts (durées pendant lesquelles aucune exposition n'a lieu) sont pratiquement nuls. Dans les conditions décrites plus haut le temps d'enregistrement d'un spectre image de 64 x 64 points et de :

$$Te = (TpLL + TpCL) * 64 * 64 = 153,1s \, .$$

On choisit maintenant des blocs de 104 lignes, dans ce cas le capteur d'image 17 contient 20 spectres, N=20. Il faut évidemment adapter la hauteur du spectre. Ce dernier est limité à 1.456 mm par réglage du courant d'une lentille associée au spectromètre, ou en diaphragmant le faisceau à la sortie du spectromètre. Les durées deviennent alors :

a) Transfert des zones de pertes lointaines CL :

$$TtCL = TpLL = 0,624 \, ms :$$

b) Lecture de la zone de faibles pertes LL :

$$TILL = TICL = TpCL = 14,326 \text{ ms}$$

Avec

$$FICL = 73 \text{ kHz}$$

On peut alors calculer le gain de dynamique :

$$Gd = \frac{13,702}{0,624} * 104 * 4 = 9135$$

$$Dg = Gd*Dc$$
$$Dg = 2,42 * 10^8$$

Dans ces conditions, le temps d'acquisition d'un spectre image de 128 x 128 points est de :

$$Te = 14,326 * 128 * 128 = 234,7 \text{ s}$$

La présente invention s'applique à l'analyse quantitative. L'analyse quantitative de spectres de pertes d'énergie d'électrons repose sur la connaissance de l'intégrale totale du spectre. La dynamique de celui-ci (supérieur à $10^8$) nécessite avec les capteurs actuels une double prise d'informations avec changement des conditions opératoires. Ce travail n'est pas facilité à cause de la quasi absence de procédures automatiques permettant de recueillir ces données.

Dans le spectre illustré en figure 6, on voit la raie K du Carbone. Son intensité est très faible et superposée sur un fond continu.

On observe que la présente invention permet d'obtenir jusqu'à 700 spectres par seconde, soit 7 fois plus que les dispositifs de l'art antérieur.

La présente invention s'applique aussi à l'autoréférence des spectres. Le dispositif objet de la présente invention permet l'acquisition du pic sans pertes d'énergie qui est l'origine du spectre de pertes d'énergie. Ainsi, il est envisageable de connaître, avec une précision de quelques centièmes d'électrons volts, la position absolue d'une perte d'énergie. Dans l'art antérieur, cette mesure supposait une stabilité de la haute tension du microscope (100.000 à 200.000 Volts soit 0.1 ppm) sur une période de temps de l'ordre de la minute. Au contraire, le dispositif objet de la présente invention n'a besoin de cette stabilité que sur une durée inférieure à la seconde.

Dans le cas du spectre illustré en figure 6, la position absolue du pic du fer (autour de 708 eV) ou du nickel donne une information sur leur état d'oxydation.

La présente invention s'applique aussi à l'accès au spectre de diffusion simple. Encore une fois, la connaissance du spectre complet permet avec un calcul soit de type « Fourier-Log » soit de type « Fourier-ratio » d'accéder au spectre de diffusion simple. Outre l'accès à l'épaisseur locale de l'échantillon, ce traitement ouvre l'accès aux quantifications de spectres avec des références. En effet, les diffusions multiples changent la forme des seuils de pertes d'énergie de façon non linéaires ; cela rend très complexes, voire impossibles les quantifications des données avec les outils de l'art antérieur.

La présente invention s'applique aussi à l'amélioration de la résolution en énergie. Le fait d'avoir le spectre complet permet d'améliorer la résolution en énergie de spectres grâce à des algorithmes basés sur le maximum de vraisemblance (« Richardson-Lucy ») ou sur le maximum d'entropie. Avec une extension simple, c'est une alternative prometteuse aux algorithmes précédents. On accède aux diffusions simples avec un résultat moins bruité et mieux résolu en énergie.

La présente invention s'applique aussi au travail en mode image ou spectroscopie avec le même capteur d'image. Pour les microscopes dont le spectromètre est intégré à la colonne, principalement fabriqués par LEO Microscopie Electronique, division de Carl Zeiss, marques déposées, et JEOL (Japan Electron Microscopy Limited), marque déposée, il est nécessaire d'avoir une caméra capable de travailler à la fois en mode image et spectroscopie. Le dispositif objet de la présente invention répond parfaitement à ces conditions.

La présente invention s'applique aussi aux « spectre-images ». Depuis 1990, au laboratoire de Physique des Solides, nous avons développé la technique dite "spectre-images" qui consiste en l'acquisition d'un spectre de pertes d'énergie d'électrons en chaque point de l'échantillon lors du balayage de celui-ci par une sonde électronique. Notre capteur, en ajoutant quelques millisecondes au temps par pixel, permet d'avoir toutes les informations quantitatives citées plus haut. Il fera faire de grands progrès à cette technique. De plus, nous possédons d'ores et déjà une grande majorité des outils informatiques nécessaire au stockage et au traitement d'un tel volume de données.

**Revendications**

**1.** - Dispositif pour l'acquisition d'images et/ou de spectres de perte d'énergie d'électrons, comportant :

- un capteur d'image (17),
- des moyens de lecture du capteur adapté à générer un signal représentatif de l'image captée par chaque partie photosensible du capteur d'image,
- un moyen de combinaison (35) de deux parties d'image pour former un spectre charactérisé en ce qu'il comporte une commande (31) d'au moins deux déflecteurs (48a et 48b) adapté à exposer alternativement au moins deux parties photosensibles du capteur d'image, un moyen de synchronisation (31) du déflecteur et des moyens de lecture adapté à commander successivement, pour chaque partie photosensible, d'une part l'exposition de ladite partie photosensible et, d'autre part, la lecture d'une autre partie photosensible différente.

**2.** - Dispositif selon la revendication 1, **caractérisé en ce que** le moyen de synchronisation (31) est adapté à commander des durées d'exposition différentes pour différents intervalles de temps successifs d'exposition.

**3.** - Dispositif selon l'une quelconque des revendications 1 ou 2, **caractérisé en ce que** le moyen de synchronisation (31) est adapté à ce que les vitesses de lectures des différentes zones photosensibles soient différentes.

**4.** - Dispositif selon la revendication 3, **caractérisé en ce que** le moyen de lecture (17) est adapté à effectuer, d'une part, une lecture ligne à ligne d'une partie photosensible et, d'autre part, une accumulation de charges électriques de photosites d'une partie photosensible avant lecture.

**5.** - Dispositif selon l'une quelconque des revendications 1 à 4, **caractérisé en ce qu'**il comporte un moyen de sommation (35) adapté à additionner les valeurs des signaux correspondant à différentes lignes d'une partie lue ligne à ligne.

**6.** - Dispositif selon l'une quelconque des revendications 1 à 5, **caractérisé en ce que** le capteur d'image (17) comporte, pour au moins une partie photosensible, au moins deux parties dont les moyens de lecture sont indépendants.

**7.** - Dispositif selon l'une quelconque des revendications 1 à 6, **caractérisé en ce qu'**il comporte deux déflecteurs (48a, 48b) adaptés à décaler l'image selon les deux directions du capteur d'image.

**8.** - Dispositif selon l'une quelconque des revendications 1 à 7, **caractérisé en ce qu'**il comporte, en outre, un déflecteur rapide d'effacement (60) adapté à déporter le spectre hors du détecteur pendant le positionnement de chaque autre déflecteur (48a, 48b) servant à exposer alternativement au moins deux parties photosensibles du capteur d'image.

**9.** - Dispositif selon l'une quelconque des revendications 1 à 8, **caractérisé en ce que** le déflecteur (48a) qui agit sur le spectre dans le sens dispersif en énergie est de type électrostatique, la variation de potentiel étant obtenue par un commutateur électronique qui permet le basculement instantané de la tension de consigne haute à la masse.

**10.** - Dispositif selon l'une quelconque des revendications 1 à 9, **caractérisé en ce que** les déflecteurs (48a, 48b) sont adaptés à décaler l'image selon les deux directions du capteur d'image (17).

**11.** - Dispositif selon l'une quelconque des revendications 1 à 10, **caractérisé en ce que** l'un au moins des déflecteurs (48b) est de type magnétique.

**12.** - Dispositif selon l'une quelconque des revendications 1 à 11, **caractérisé en ce qu'**il comporte un moyen de transfert optique comportant au moins une lentille.

**13.** - Dispositif selon l'une quelconque des revendications 1 à 12, **caractérisé en ce qu'**il comporte un spectromètre (12) adapté à former, à la surface du capteur d'image (17), un spectre de perte d'énergie d'électrons.

**14.** - Dispositif selon l'une quelconque des revendications 1 à 13, **caractérisé en ce que** les moyens de lecture du capteur sont adaptés à appliquer des gains différents aux signaux issus des deux parties photosensibles du capteur d'image.

**Claims**

**1.** A device for the acquisition of images and/or electron energy loss spectra, including:

- an image sensor (17),
- sensor reading means adapted for generating a signal representative of the image collected with each photosensitive part of the image sensor,
- means for combining (35) two parts of an image to form a spectrum,
**characterized in that** it includes:

- a control (31) for at least two deflectors (48a and 48b) adapted for alternately exposing at least two photosensitive parts of the image sensor,
- means for synchronizing (31) the deflector and reading means adapted for successively controlling, for each photosensitive part, on the one hand the exposure of said photosensitive part, and on the other hand, the reading of another different photosensitive part.

**2.** A device according claim 1, **characterized in that** the synchronisation means (31) is adapted for controlling different exposure times for different successive exposure time slots.

**3.** A device according to any one of claims 1 or 2,
**characterized in that** the synchronisation means (31) is adapted to the reading speeds of the different photosensitive zones being different.

**4.** A device according to claim 3, **characterized in that** the reading means (17) is adapted for performing, on the one hand a line for line reading of a photosensitive part, and, on the other hand, an accumulation of electric charges of photosites of a photosensitive part, prior to the reading.

**5.** A device according to any one of claims 1 to 4,
**characterized in that** it includes summation means (35) adapted for adding the values of the signals corresponding to different lines of a part read line for line.

**6.** A device according to any one of claims 1 to 5,
**characterized in that** the image sensor (17) includes, for at least one photosensitive part, two parts the reading means of which are independent from each other.

**7.** A device according to any one of claims 1 to 6,
**characterized in that** it includes two deflectors (48a, 48b) adapted for shifting the image according to both directions of the image sensor.

**8.** A device according to any one of claims 1 to 7,
**characterized in that** it further includes a quick erasing deflector (60) adapted for shifting the spectrum out of the sensor during the positioning of each other deflector (48a, 48b) used for alternately exposing at least two photosensitive parts of the image sensor.

**9.** A device according to any one of claims 1 to 8,
**characterized in that** the deflector (48a) which acts on the spectrum in the energy dispersion direction is of the electrostatic type, the potential variation being obtained by an electronic switch enabling the instantaneous switching from the high reference voltage to the ground.

**10.** A device according to any one of claims 1 to 9, **characterized in that** the deflectors (48a, 48b) are adapted for shifting the image according to both directions of the image sensor (17).

11. A device according to any one of claims 1 to 10, **characterized in that** at least one of the deflectors (48b) is of the magnetic type.

12. A device according to any one of claims 1 to 11, **characterized in that** it includes optical transfer means including at least one lens.

13. A device according to any one of claims 1 to 12,
**characterized in that** it includes a spectrometer (12) adapted to form an electron energy loss spectrum at the surface of the image sensor (17).

14. A device according to any one of claims 1 to 13, **characterized in that** the sensor reading means is adapted for applying different grains to the signals originating from the two photosensitive parts of the image sensor.

**Patentansprüche**

1. Vorrichtung zur Erfassung von Bildern und/oder Elektronenenergieverlustspektren, umfassend:

   - einen Bildsensor (17),
   - Lesemittel des Sensors, geeignet, um ein Signal zu erzeugen, das das von jedem fotoempfindlichen Teil des Bildsensors erfasste Bild darstellt,
   - ein Kombinationsmittel (35) zweier Bildteile, um ein Spektrum zu bilden,
   **dadurch gekennzeichnet, dass** sie folgendes umfasst:

      - eine Steuerung (31) von mindestens zwei Deflektoren (48a und 48b), geeignet, um abwechselnd mindestens zwei fotoempfindliche Teile des Bildsensors zu belichten,
      - ein Synchronisierungsmittel (31) des Deflektors und der Lesemittel, geeignet, um nacheinander für jedes fotoempfindliche Teil einerseits die Belichtung des genannten fotoempfindlichen Teils und andererseits das Lesen eines anderen, unterschiedlichen fotoempfindlichen Teils zu steuern.

2. Vorrichtung gemäß Anspruch 1, **dadurch gekennzeichnet, dass** das Synchronisierungsmittel (31) geeignet ist, um verschiedene Belichtungsdauern für verschiedene, aufeinanderfolgende Belichtungszeitintervalle zu steuern.

3. Vorrichtung gemäß einem der Ansprüche 1 oder 2, **dadurch gekennzeichnet, dass** das Synchronisierungsmittel (31) dazu geeignet ist, dass die Lesegeschwindigkeiten der verschiedenen fotoempfindlichen Zonen unterschiedlich sind.

4. Vorrichtung gemäß Anspruch 3, **dadurch gekennzeichnet, dass** das Lesemittel (17) geeignet ist, um einerseits ein zeilenweises Lesen eines fotoempfindlichen Teils und andererseits eine Akkumulation von Strombelastungen von Fotoplätzen eines fotoempfindlichen Teils vor dem Lesen durchzuführen.

5. Vorrichtung gemäß einem der Ansprüche 1 bis 4, **dadurch gekennzeichnet, dass** sie ein Summierungsmittel (35) umfasst, geeignet, um die Werte der verschiedenen Zeilen eines zeilenweise gelesenen Teils entsprechenden Signale zu addieren.

6. Vorrichtung gemäß einem der Ansprüche 1 bis 5, **dadurch gekennzeichnet, dass** der Bildsensor (17) für mindestens ein fotoempfindliches Teil mindestens zwei Teile umfasst, deren Lesemittel unabhängig sind.

7. Vorrichtung gemäß einem der Ansprüche 1 bis 6, **dadurch gekennzeichnet, dass** sie zwei Deflektoren (48a, 48b) umfasst, geeignet, um das Bild nach den beiden Richtungen des Bildsensors zu versetzen.

8. Vorrichtung gemäß einem der Ansprüche 1 bis 7, **dadurch gekennzeichnet, dass** sie ferner einen Schnelllöschungsdeflektor (60) umfasst, geeignet, um das Spektrum nach außerhalb des Sensors zu verlagern, während der Positionierung jedes anderen Deflektors (48a, 48b), um mindestens zwei fotoempfindliche Teile des Bildsensors abwechselnd zu belichten.

9. Vorrichtung gemäß einem der Ansprüche 1 bis 8, **dadurch gekennzeichnet, dass** der Deflektor (48a), der in energiestreuender Richtung auf das Spektrum wirkt, von elektrostatischem Typ ist, wobei die Potentialschwankung über einen elektronischen Schalter erhalten wird, der das sofortige Umschalten der hohen Sollspannung auf die Masse ermöglicht.

10. Vorrichtung gemäß einem der Ansprüche 1 bis 9, **dadurch gekennzeichnet, dass** die Deflektoren (48a, 48b) geeignet sind, um das Bild nach den beiden Richtungen des Bildsensors (17) zu versetzen.

11. Vorrichtung gemäß einem der Ansprüche 1 bis 10, **dadurch gekennzeichnet, dass** mindestens einer der Deflektoren (48b) von magnetischem Typ ist.

12. Vorrichtung gemäß einem der Ansprüche 1 bis 11, **dadurch gekennzeichnet, dass** sie ein optisches Übertragungsmittel mit mindestens einer Linse umfasst.

13. Vorrichtung gemäß einem der Ansprüche 1 bis 12, **dadurch gekennzeichnet, dass** sie ein Spektrometer (12) umfasst, geeignet, um an der Oberfläche des Bildsensors (17) ein Elektronenenergieverlustspektrum zu bilden.

14. Vorrichtung gemäß einem der Ansprüche 1 bis 13, **dadurch gekennzeichnet, dass** die Lesemittel des Sensors geeignet sind, um die aus den beiden fotoempfindlichen Teilen des Bildsensors kommenden Signale mit verschiedenen Verstärkungen zu beaufschlagen.

Figure 1

Figure 2

Figure 3

1125 ns

PhiL1

PhiL2

PhiS

PhiR

Blocage

Binning 1

Binning 2

Décalage Dynamique

Présence Pixel

Figure 4

EP 1 787 309 B1

hnb =1054

7 références noir

5 isolation

18 extra pixels

3 | 4 — 3 lignes masquées

2080 pixels utiles

— 5 lignes supplémentaires

ZONE A — 512 lignes utiles

— 8 lignes supplémentaires

ZONE B — 512 lignes utiles

— 512 lignes utiles

ZONE C

— 8 lignes supplémentaires

ZONE D

— 5 lignes supplémentaires

1 | 2 — 3 lignes masquées

A

Figure 5A

Figure 5B

EP 1 787 309 B1

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2001148231 B